(19) Europäisches Patentamt
European Patent Office
Office européen des brevets

(11) **EP 4 035 933 B1**

(12) **EUROPÄISCHE PATENTSCHRIFT**

(45) Veröffentlichungstag und Bekanntmachung des Hinweises auf die Patenterteilung:
**13.08.2025 Patentblatt 2025/33**

(21) Anmeldenummer: **22154009.9**

(22) Anmeldetag: **28.01.2022**

(51) Internationale Patentklassifikation (IPC):
**B60L 53/18** (2019.01)  **B60L 53/65** (2019.01)
**B60L 53/66** (2019.01)  **G01B 7/02** (2006.01)
**G08C 19/00** (2006.01)  **G08C 19/16** (2006.01)
**H04B 3/14** (2006.01)  **H04B 3/54** (2006.01)
**B60L 53/30** (2019.01)

(52) Gemeinsame Patentklassifikation (CPC):
**B60L 53/18; B60L 53/30; B60L 53/65; B60L 53/66; G08C 19/00; H04B 3/548;** B60L 2270/147

(54) **ELEKTRONISCHE SCHALTUNGSANORDNUNG UND VERFAHREN**

ELECTRONIC MEASUREMENT CIRCUIT AND METHOD

AGENCEMENT DE CIRCUIT ÉLECTRONIQUE ET PROCÉDÉ

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **02.02.2021 DE 102021200913**

(43) Veröffentlichungstag der Anmeldung:
**03.08.2022 Patentblatt 2022/31**

(73) Patentinhaber: **MAHLE International GmbH**
**70376 Stuttgart (DE)**

(72) Erfinder:
• **EWERT, Sebastian**
**70180 Stuttgart (DE)**
• **GERSTADT, Max**
**70567 Stuttgart (DE)**
• **WAGNER, Michael B.**
**78628 Rottweil (DE)**

(74) Vertreter: **BRP Renaud & Partner mbB**
**Rechtsanwälte Patentanwälte**
**Steuerberater**
**Königstraße 28**
**70173 Stuttgart (DE)**

(56) Entgegenhaltungen:
**EP-A1- 2 197 084    EP-A1- 2 787 597
DE-A1- 102019 113 083    US-A1- 2013 154 667
US-A1- 2014 247 893    US-A1- 2018 334 047**

**Beschreibung**

Die Erfindung betrifft eine elektronische Schaltungsanordnung für eine elektrische Ladestation sowie ein Verfahren zum Auslegen einer elektrischen Frequenzfiltereinrichtung einer derartigen elektronischen Schaltungsanordnung.

Beim konduktiven Aufladen von Elektrokraftfahrzeugen mit elektrischer Energie mittels einer elektrischen Ladestation, wobei bei einem derartigen konduktiven Aufladen das Elektrokraftfahrzeug physisch elektrisch mit der Ladestation verbunden ist, wird üblicherweise zwischen Elektrokraftfahrzeug und Ladestation eine elektrische Kommunikationsverbindung ausgebildet. Über diese elektrische Kommunikationsverbindung kommunizieren das Elektrokraftfahrzeug und die elektrische Ladestation mittels eines pulsweitenmodellierten elektrischen Signals, wobei eine positive Amplitude des Signals den Status des Fahrzeugs und die Pulsweite einen vorgegebenen und mittels der Ladestation bereitgestellten elektrischen Ladestrom darstellen.

Ein typischer Standard der elektrischen Kommunikationsverbindung bzw. des pulsweitenmodellierten Signals ist in der Norm IEC61851-1 angegeben. Hierin werden genaue Vorgaben getroffen, was die Toleranz verschiedener Parameter des Signals betrifft. Eingehalten werden müssen im Sinne der Norm ein negativer und ein positiver Spannungspegel sowie gewisse Anstiegs- und Abfallzeiten des Signals bzw. der Pulse des Signals.

Eine solche gewöhnliche elektrische Ladestation wird üblicherweise mittels einer elektrischen Anschlussleitung mit dem elektrisch aufzuladen Elektrokraftfahrzeug elektrisch verbunden, wenn das Kraftfahrzeug elektrisch aufgeladen werden soll. Je länger dabei besagte Anschlussleitung ist, desto höher sind ihr elektrischer Widerstandswert, ihr elektrischer Kapazitätswert und ihr elektrischer Induktivitätswert. Mit diesen Werten wirkt die Anschlussleitung gewöhnlich als Tiefpassfilter, sodass Anteile des elektrischen Signals mit hohen Frequenzen durch die Anschlussleitung verstärkt gedämpft werden. Ein gemäß der Norm IEC61851 vorgeschlagenes elektrisches Rechtecksignal enthält dabei ein breites Spektrum an Frequenzen, das auch höherfrequente Anteile umfasst, wobei für die Flanken des elektrischen Rechtecksignals vor allem diese hohen Frequenzen des Spektrums verantwortlich sind. Je steiler die Flanke, desto größer muss typischerweise der hochfrequente Anteil des Signals sein.

Wird das Signal nun über die Anschlussleitung gesendet, so werden diese hohen Frequenzen des Spektrums des Rechtecksignals bei herkömmlichen Ladeeinrichtungen in nachteiliger Weise gefiltert, sodass die Flankensteilheit über die Anschlussleitung abnimmt. Abhängig von der Länge und der Beschaffenheit der Anschlussleitung kann die Flankensteilheit dabei so stark abnehmen, dass sie außerhalb des genormten Sollbereichs fällt. Dies kann nachteilig dazu führen, dass Elektrokraftfahrzeuge, welche die Norm IEC61851 streng einhalten, im elektrisch angeschlossenen Zustand an die Ladeeinrichtung nicht mit elektrischer Energie aufgeladen werden, falls die Beschaffenheit der Anschlussleitung das Signal von der Norm abweichen lässt. US 2014/247893 A1 offenbart elektronische Schaltungsanordnung für eine elektrische Ladestation, wobei mittels der Schaltungsanordnung eine elektrische Kommunikationsverbindung zwischen der elektrischen Ladestation und einem mittels der Ladestation mit elektrischer Energie aufladbaren Elektrokraftfahrzeugs ausbildbar ist, mit einem elektrischen Pilotkontakt und mit einem elektrischen Massekontakt, an welche das Elektrokraftfahrzeug zur Ausbildung der elektrischen Kommunikationsverbindung elektrisch anschließbar ist, mit einem elektrischen Leitungspfad, in welchem ein elektrischer Oszillator angeordnet ist. EP 2 197 084 A1 offenbart elektronische Schaltungsanordnung für eine elektrische Ladestation, wobei mittels der Schaltungsanordnung eine elektrische Kommunikationsverbindung zwischen der Ladestation und eines Elektrokraftfahrzeugs ausbildbar ist gemäß dem Stand der Technik.

Es ist daher eine Aufgabe der vorliegenden Erfindung eine elektronische Schaltungsanordnung für eine elektrische Ladestation sowie ein Verfahren zum Auslegen einer elektrischen Frequenzfiltereinrichtung einer derartigen Schaltungsanordnung anzugeben, die der voranstehenden Problematik Rechnung trägt.

Diese Aufgabe wird durch den Gegenstand des unabhängigen Patentanspruchs 1 und das Verfahren des unabhängigen Patentanspruchs 2 gelöst. Bevorzugte Ausführungsformen sind Gegenstand der abhängigen Patentansprüche.

Grundidee der Erfindung ist demnach, eine elektronische Schaltungsanordnung für eine elektronische Ladestation, wobei mittels der Schaltungsanordnung eine elektrische Kommunikationsverbindung zwischen der elektrischen Ladestation und einem mittels der Ladestation mit elektrischer Energie aufladbaren Elektrokraftfahrzeugs ausbildbar ist, mit einer Frequenzfiltereinrichtung auszustatten, welche hohe Frequenzanteile eines über die Kommunikationsverbindung übertragbaren elektrischen Signals weniger stark bedämpft als niederfrequente Anteile des Signals. Dabei kann die Frequenzfiltereinrichtung mittels eines erfindungsgemäßen Verfahrens ausgelegt werden, welches auf dem allgemeinen Gedanken basiert, die Frequenzfiltereinrichtung in Abhängigkeit von der Beschaffenheit einer elektrischen Anschlussleitung der Ladestation bzw. der Schaltungsanordnung der Ladestation auszulegen.

Vorteilhaft lässt sich mittels einer solchen Frequenzfiltereinrichtung bzw. einer solchen Auslegung der Frequenzfiltereinrichtung der oben dargelegten Frequenzfilterwirkung der elektrischen Anschlussleitung entgegenwirken. Somit kann die Einhaltung der Norm IEC61851 verbessert gewährleistet werden.

Eine erfindungsgemäße elektronische Schaltungsanordnung für eine elektrische Ladestation, wobei mittels der Schaltungsanordnung eine elektrische Kommunikationsverbindung zwischen der elektrischen Ladestation und einem mittels der Ladestation mit elektrischer Energie aufladbaren Elektrokraftfahrzeugs ausbildbar ist, umfasst einen elektrischen Pilotkontakt sowie einen elektrischen Massekontakt. Es können zwei Pilotkontakte vorhanden sein, nämlich ein sogenannter "Proximity-Pilotkontakt" und ein sogenannter "Control-Pilotkontakt", wobei mit dem Pilotkontakt im Rahmen der vorliegenden Anmeldung vorzugsweise der Control-Pilotkontakt gemeint ist. Am Pilotkontakt und am Massekontakt ist das Elektrokraftfahrzeug zur Ausbildung der elektrischen Kommunikationsverbindung elektrisch anschließbar. Außerdem umfasst die elektronische Schaltungsanordnung einen elektrischen Leitungspfad, in welchem ein elektrischer Oszillator zum Erzeugen eines pulsweitenmodulierten elektrischen Kommunikationssignals angeordnet ist. Der Oszillator kann ein als Signalquelle fungierender Pulsweitenmodulator sein. Dabei unterteilt der Oszillator den Leitungspfad zumindest in einen vom Oszillator abgewandt im Pilotkontakt endenden Pilotabschnitt und in einen vom Oszillator abgewandt im Massekontakt endenden Masseabschnitt. Ein elektrischer Parallel-Leitungspfad der Schaltungsanordnung, in welchem eine elektrische Kapazität angeordnet ist, ist mit dem Pilotabschnitt und mit dem Masseabschnitt elektrisch parallel zum Oszillator verbunden. Der elektrische Masseabschnitt kann elektrisch geerdet sein. Die elektrische Kapazität im Parallel-Leitungspfad kann Teil eines Tiefpassfilters der elektronischen Schaltungsanordnung sein. Dabei ist im Pilotabschnitt des elektrischen Leitungspfades eine, insbesondere parametrisierbare, Frequenzfiltereinrichtung zum Filtern des elektrischen Kommunikationssignals angeordnet. Im Pilotabschnitt ist eine elektrische Spannungsmesseinrichtung, mittels welcher eine zwischen Pilot- und Massekontakt anliegende elektrische Spannung messbar ist, zwischen Pilotkontakt und Frequenzfiltereinrichtung elektrisch an den elektrischen Leitungspfad angeschlossen. Wie oben bereits angedeutet lässt sich mittels der Frequenzfiltereinrichtung der erfindungsgemäßen elektronischen Schaltungsanordnung vorteilhaft der unerwünschten Frequenzfilterwirkung der elektrischen Anschlussleitung entgegenwirken, sodass die Einhaltung der genormten Vorgaben im Hinblick auf die elektrische Kommunikationsverbindung verbessert gewährleistet werden kann.

Die Erfindung betrifft ferner ein Verfahren zum Auslegen einer elektrischen Frequenzfiltereinrichtung der voranstehend beschriebenen elektronischen Schaltungsanordnung gemäß der Erfindung. Gemäß dem Verfahren wird die Frequenzfiltereinrichtung in Abhängigkeit von der Beschaffenheit, insbesondere von der elektrischen Impedanz, einer den Pilotabschnitt und den Masseabschnitt des elektrischen Leitungspfads wenigstens bereichsweise festlegenden elektrischen Anschlussleitung parametrisiert. Dabei ist bzw. wird die Beschaffenheit der Anschlussleitung wenigstens durch ein Ausgewähltes aus einer Länge der elektrischen Anschlussleitung, einem elektrischen Widerstandswert der Anschlussleitung, einem elektrischen Kapazitätswert der Anschlussleitung und einem elektrischen Induktivitätswert der Anschlussleitung festgelegt. Das erfindungsgemäße Verfahren erlaubt es vorteilhaft, die oben dargelegten Vorteile der erfindungsgemäßen elektronischen Schaltungsanordnung mit der mittels des Verfahrens ausgelegten Frequenzfiltereinrichtung in besonders großem Umfang auszunutzen - und zwar auch, falls verschiedenen beschaffenen elektrischen Anschlussleitungen an Ladestationen gleichen Typs verwendet werden.

Zweckmäßig wird bei der Durchführung des Verfahrens die Beschaffenheit der Anschlussleitung ermittelt wird. Damit lässt sich die Frequenzfiltereinrichtung besonders präzise auf die Beschaffenheit der konkret verwendeten Anschlussleitung abstimmen.

Gemäß einer bevorzugten Weiterbildung des Verfahrens legt die Anschlussleitung den Pilotabschnitt und den Masseabschnitt des elektrischen Leitungspfads in einem Bereich fest, der außerhalb eines von einem Gehäuse der elektrischen Ladestation begrenzten Gehäuseinnenraums vorhanden ist. Dabei sind im Gehäuseinnenraum die Frequenzfiltereinrichtung, der Oszillator, die Kapazität und ein abseits der Anschlussleitung gelegener Restbereich des elektrischen Leitungspfades angeordnet. Der Bereich, in welchem die Anschlussleitung den Pilot- und den Masseabschnitt des elektrischen Leitungspfads festlegt, kann durch ein Kabel mit zwei elektrisch voneinander isolierten Litzen für Pilot- und Masseabschnitt gebildet sein. Es kann also für die Auslegung der Frequenzfiltereinrichtung mittels des Verfahrens bei dieser Weiterbildung die Beschaffenheit eines solchen Kabels berücksichtigt werden. Dies erweist sich besonders dann als vorteilhaft, wenn - insbesondere im Hinblick auf ihre Länge oder eine sonstige Beschaffenheit - verschiedene Kabel wahlweise verwendet werden.

Bei einer weiteren vorteilhaften Weiterbildung des Verfahrens weist die Frequenzfiltereinrichtung einen elektrischen Filterwiderstandswert und einen elektrischen Filterkapazitätswert und einen elektrischen Filterinduktivitätswert auf, die jeweils zu gleich oder größer null parametrisierbar sind. Der Filterwiderstandswert kann also zu gleich oder größer 0 Ohm parametrisiert werden. Der Filterkapazitätswert kann zu gleich oder größer 0 Farad parametrisiert werden. Der Filterinduktivitätswert kann zu gleich oder größer 0 Henry parametrisiert werden. Dabei wird die Frequenzfiltereinrichtung anhand einer Wertetabelle parametrisiert, in welcher inkrementelle Beschaffenheitswerte für wenigstens ein Ausgewähltes aus der Länge der elektrischen Anschlussleitung, dem elektrischen Widerstandswert der Anschlussleitung, dem elektrischen Kapazitätswert der Anschlussleitung und dem elektrischen Induktivitätswert der Anschlussleitung inkrementellen Parameterwerten für den elektrischen Filterwiderstandswert und den elektrischen Filterkapazitätswert und den elektrischen Filterinduktivitätswert, insbesondere clusterartig, zugeordnet sind. Eine solche Auslegung der Frequenzfiltereinrichtung lässt sich technisch besonders einfach realisieren.

Zweckmäßig werden der Pilot- und der Massekontakt beim Ermitteln der Beschaffenheit der Anschlussleitung elektrisch kurzgeschlossen. Somit kann die Ermittlung der Beschaffenheit der Anschlussleitung sowohl für den Pilot- als auch für den Masseabschnitt in einem Zug erfolgen.

Bei einer vorteilhaften Weiterbildung des Verfahrens wird dem Pilotabschnitt des elektrischen Leitungspfads ein elektrischer Messwiderstand mit vorbestimmtem Messwiderstandswert elektrisch in Reihe geschaltet. Dann wird mittels einer elektrischen Spannungsquelle eine konstante elektrische Spannung vorbestimmten Spannungswerts erzeugt und an einem vom Pilotkontakt und vom Massekontakt abgewandten gemeinsamen Ende der Anschlussleitung an den Pilotabschnitt und den Masseabschnitt angelegt. Ein Spannungswert der über den Messwiderstand abfallenden elektrischen Spannung wird gemessen. Schließlich wird die Beschaffenheit der Anschlussleitung wenigstens durch den elektrischen Widerstandswert der Anschlussleitung festgelegt, der aus den Spannungswerten der vorbestimmten konstanten elektrischen Spannung und der gemessenen über den Messwiderstand abfallenden elektrischen Spannung berechnet wird. Vorteilhaft lässt sich somit die Beschaffenheit der Anschlussleitung besonders präzise ermitteln.

Bei einer anderen bevorzugten Weiterbildung des Verfahrens wird mittels einer elektrischen Stromquelle ein konstanter elektrischer Strom vorbestimmter Stromstärke erzeugt und an einem vom Pilotkontakt und vom Massekontakt abgewandten gemeinsamen Ende der Anschlussleitung an den Pilotabschnitt und den Masseabschnitt angelegt. Ein Spannungswert der über den Pilotabschnitt und den Masseabschnitt abfallenden elektrischen Spannung wird gemessen. Dabei wird die Beschaffenheit der Anschlussleitung wenigstens durch den elektrischen Widerstandswert der Anschlussleitung festgelegt, der aus der vorbestimmten Stromstärke und dem gemessenen Spannungswert der über den Pilotabschnitt und den Masseabschnitt abfallende elektrischen Spannung berechnet wird. Auch dies erlaubt eine besonders präzise Ermittlung der Beschaffenheit der Anschlussleitung.

Gemäß einer weiteren bevorzugten Weiterbildung des Verfahrens wird die Beschaffenheit der Anschlussleitung zusätzlich wenigstens durch die Länge der Anschlussleitung festgelegt. Dabei wird die Länge der Anschlussleitung aus einem vorbestimmten elektrischen Widerstandsbelag der Anschlussleitung und dem berechneten elektrischen Widerstandswert der Anschlussleitung berechnet. Damit lässt sich die Beschaffenheit der Anschlussleitung noch genauer ermitteln.

Bei einer anderen vorteilhaften Weiterbildung des Verfahrens wird die Beschaffenheit der Anschlussleitung wenigstens durch die Länge der Anschlussleitung bestimmt. Mittels einer elektrischen Spannungspulsquelle wird ein elektrischer Spannungsimpuls erzeugt und von einem vom Pilotkontakt abgewandten Ende der Anschlussleitung ausgehend durch den in der Anschlussleitung vorhandenen Bereich des Pilotabschnitts geschickt, wobei der Pilotkontakt frei liegt. Der Spannungsimpuls wird am Pilotkontakt reflektiert. Dann wird der reflektierte Spannungsimpuls am vom Pilotkontakt abgewandten Ende der Anschlussleitung detektiert. Dabei wird eine Laufzeit zwischen Erzeugung des Spannungsimpulses und Detektion des reflektierten Spannungsimpulses gemessen. Schließlich wird anhand einer vorbestimmten Ausbreitungsgeschwindigkeit elektrischer Spannung auf der Anschlussleitung und der gemessenen Laufzeit die Länge der Anschlussleitung berechnet. Vorteilhaft lässt sich so die Beschaffenheit der Anschlussleitung ermitteln, ohne zuvor Massekontakt und Pilotkontakt elektrisch kurzschließen zu müssen.

Gemäß einer anderen vorteilhaften Weiterbildung des Verfahrens wird die Beschaffenheit der Anschlussleitung wenigstens durch den elektrischen Kapazitätswert der Anschlussleitung festgelegt. Dabei wird der Kapazitätswert der Anschlussleitung gemessen. Auch auf diese Weise lässt sich die Beschaffenheit der Anschlussleitung sehr genau bestimmen.

Die Frequenzfiltereinrichtung der Schaltungsanordnung umfasst einen Hochpassfilter oder/und einen Bandpassfilter. Somit kann die Schaltungsanordnung noch besser auf Einhaltung der Norm IEC61851 getrimmt werden.

Gemäß einer weiteren bevorzugten Weiterbildung der Schaltungsanordnung ist die Frequenzfiltereinrichtung analog oder/und digital auslegbar bzw. ausgelegt, insbesondere parametrisierbar bzw. parametrisiert. Bei einer entsprechenden weiteren vorteilhaften Weiterbildung des Verfahrens wird die Frequenzfiltereinrichtung analog oder/und digital ausgelegt, insbesondere parametrisiert. Dies erlaubt eine technisch besonders einfach umzusetzende Auslegung der Frequenzfiltereinrichtung.

Gemäß einer weiteren vorteilhaften Weiterbildung der Schaltungsanordnung bzw. des Verfahrens umfasst die Frequenzfiltereinrichtung genau einen elektrischen Widerstand und genau eine elektrische Kapazität, wobei die Kapazität dem Widerstand elektrisch parallel geschaltet ist. Eine solche Frequenzfiltereinrichtung erweist sich als besonders robust.

Zusammenfassend betrifft die Erfindung eine elektronische Schaltungsanordnung für eine elektrischen Ladestation, mit einem elektrischen Pilotkontakt und mit einem elektrischen Massekontakt, an welche ein Elektrokraftfahrzeug zur Ausbildung der elektrischen Kommunikationsverbindung elektrisch anschließbar ist und mit einem elektrischen Leitungspfad, in welchem ein elektrischer Oszillator zum Erzeugen eines pulsweitenmodulierten elektrischen Kommunikationssignals angeordnet ist, wobei der Oszillator den elektrischen Leitungspfad in einen im Pilotkontakt endenden Pilotabschnitt und in einen im Massekontakt endenden Masseabschnitt unterteilt, wobei im Pilotabschnitt des elektrischen Leitungspfades eine Frequenzfiltereinrichtung angeordnet ist.

Weitere wichtige Merkmale und Vorteile der Erfindung ergeben sich aus den Unteransprüchen, aus den Zeichnungen und aus der zugehörigen Figurenbeschreibung anhand der Zeichnungen.

Es versteht sich, dass die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Bevorzugte Ausführungsbeispiele der Erfindung sind in den Zeichnungen dargestellt und werden in der nachfolgenden Beschreibung näher erläutert, wobei sich gleiche Bezugszeichen auf gleiche oder ähnliche oder funktional gleiche Komponenten beziehen.

Es zeigen, jeweils schematisch

Fig. 1     in schaltplanartiger Darstellung, ein Beispiel einer erfindungsgemäßen elektronischen Schaltungsanordnung für eine elektrische Ladestation,

Fig. 2     ein weiteres Beispiel der erfindungsgemäßen elektronischen Ladestation in einer schaltplanartigen Darstellung.

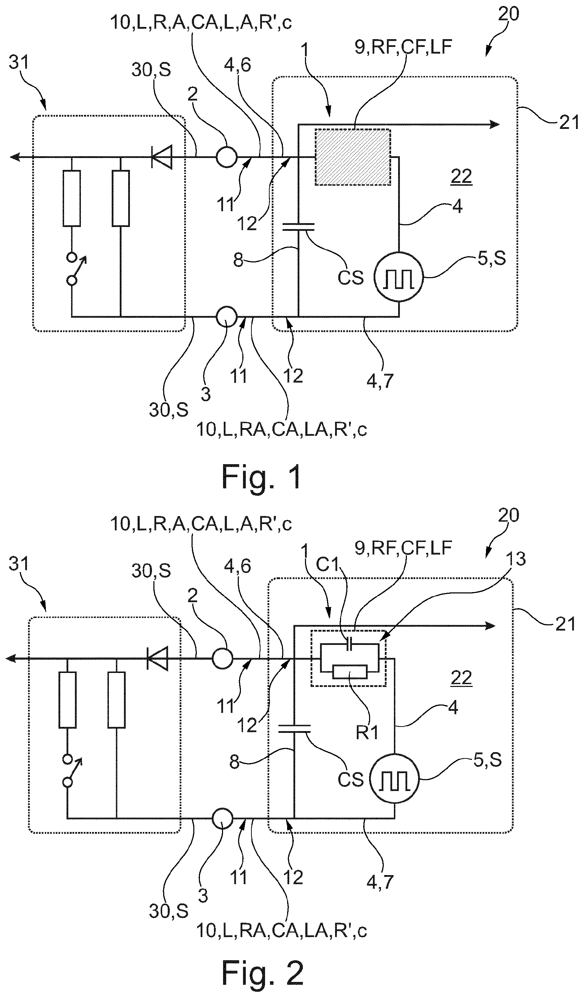

In der Figur 1 ist ein Beispiel einer erfindungsgemäßen elektronischen Schaltungsanordnung 1 für eine elektrische Ladestation 20 schaltplanartig dargestellt. Mittels der Schaltungsanordnung 1 kann eine elektrische Kommunikationsverbindung 30 zwischen der elektrischen Ladestation 20 - die im Beispiel der Figur 1 die erfindungsgemäße Schaltungsanordnung 1 umfasst - und einem mittels der Ladestation 20 mit elektrischer Energie aufladbaren Elektrokraftfahrzeugs 31 ausgebildet werden. Die elektronische Schaltungsanordnung 1 umfasst einen elektrischen Pilotkontakt 2 und einen elektrischen Massekontakt 3, an welche das Elektrokraftfahrzeug 31 zur Ausbildung der elektrischen Kommunikationsverbindung 30 elektrisch anschließbar ist. Außerdem weist die elektronische Schaltungsanordnung 1 einen elektrischen Leitungspfad 4 auf, in welchem ein elektrischer Oszillator 5 zum Erzeugen eines pulsweitenmodulierten elektrischen Kommunikationssignals S angeordnet ist. Der Oszillator 5 kann also ein als Signalquelle fungierender Pulsweitenmodulator sein. Das mittels des Oszillators 5 erzeugte Kommunikationssignals S kann über die Kommunikationsverbindung 30 von der Ladestation 20 an das Elektrokraftfahrzeug 31 übertragen werden. Auch das Kraftfahrzeug 31 kann gegebenenfalls über die Kommunikationsverbindung 30 ein elektrisches Signal an die Ladestation 20 senden.

Die Figur 1 lässt ferner erkennen, dass der Oszillator 5 den elektrischen Leitungspfad 4 zumindest in einen Pilotabschnitt 6 und in einen Masseabschnitt 7 des elektrischen Leitungspfads 4 unterteilt. der Masseabschnitt 7 kann elektrisch geerdet sein. Dabei endet der Pilotabschnitt 6 des elektrischen Leitungspfads 4 vom Oszillator 5 abgewandt im Pilotkontakt 2. Der Masseabschnitt 7 des elektrischen Leitungspfads 4 endet vom Oszillator 5 abgewandt im Massekontakt 3. Darüber hinaus umfasst die elektronische Schaltungsanordnung 1 einen elektrischen Parallel-Leitungspfad 8, in welchem eine elektrische Kapazität CS angeordnet ist. Der elektrische Parallel-Leitungspfad 8 ist unter Ausbildung einer elektrischen Parallelschaltung der elektrischen Kapazität CS zum Oszillator 5 einen Ends mit dem Pilotabschnitt 6 und anderen Ends mit dem Masseabschnitt 7 des elektrischen Leitungspfads 4 elektrisch verbunden.

Dabei ist gemäß Figur 1 im Pilotabschnitt 6 des elektrischen Leitungspfads 4 eine Frequenzfiltereinrichtung 9 zum Filtern von des elektrischen Kommunikationssignals K angeordnet. Diese Frequenzfiltereinrichtung 9 kann parametrisierbar sein, sodass durch Auslegung bzw. Parametrisierung der Frequenzfiltereinrichtung 9 eingestellt werden kann, welche Frequenzen elektrischer Spannung durch die Frequenzfiltereinrichtung 9 wie stark gedämpft werden. Im Pilotabschnitt 6 ist außerdem - zwischen Pilotkontakt 2 und Frequenzfiltereinrichtung 9 - eine elektrische Spannungsmesseinrichtung, mittels welcher eine zwischen Pilot- und Massekontakt 2, 3 anliegende elektrische Spannung messbar ist, an den elektrischen Leitungspfad 4 elektrisch angeschlossen. Diese Spannungsmesseinrichtung selbst ist in der Figur 1 nicht gezeigt; allerdings verdeutlicht eine nach rechts zugespitzte Pfeillinie schematisch die Führung einer elektrischen Messleitung 14, mittels welcher die zu messende elektrische Spannung der Spannungsmesseinrichtung zuführbar ist.

Die Figur 2 zeigt ebenfalls in einer schaltplanartigen Darstellung ein weiteres Beispiel der erfindungsgemäßen elektronischen Schaltungsanordnung 1, das sich von jenem der Figur 1 ausschließlich in der konkreten Ausgestaltung der Frequenzfiltereinrichtung 9 unterscheidet. Wohingegen die Frequenzfiltereinrichtung 9 in der Figur 1 zur Blackbox abstrahiert ist, gibt die Figur 2 ein Ausführungsbeispiel der elektronischen Schaltungsanordnung 1 mit einer Frequenzfiltereinrichtung 9 an, die einen Hochpassfilter 13 umfasst. Gemäß Figur 2 umfasst die Frequenzfiltereinrichtung 9 bzw. ihr Hochpassfilter 13 genau einen elektrischen Widerstand R1 und genau eine elektrische Kapazität C1, wobei die Kapazität C1 dem elektrischen Widerstand R1 elektrisch parallel geschaltet ist.

Die Frequenzfiltereinrichtung 9 des Beispiels der Figur 1 kann - alternativ zum Beispiel der Figur 2 - einen Bandpassfilter umfassen. Die Frequenzfiltereinrichtung 9 kann aber auch eine Kombination aus Hochpassfilter 13 und Bandpassfilter aufweisen, wobei Hochpassfilter und Bandpassfilter dann freilich zusammen bandpassfilterartig wirken. Die Frequenzfiltereinrichtung 9 ist beispielsweise analog sowie - alternativ oder zusätzlich - digital auslegbar, insbesondere parametrisierbar.

Die Frequenzfiltereinrichtungen 9 der beispielhaft in den Figuren 1 und 2 gezeigten elektronischen Schaltungsanordnungen 1 sind mittels eines erfindungsgemäßen Verfahrens ausgelegt. Gemäß diesem Verfahren wird die Frequenzeinrichtung 9 in Abhängigkeit von der Beschaffenheit einer den Pilotabschnitt 6 und den Masseabschnitt 7 des elektrischen Leitungspfads 4 wenigstens bereichsweise festlegenden elektrischen Anschlussleitung 10 parametrisiert. Die Beschaffenheit der Anschlussleitung 10 kann eine elektrische Impedanz der elektrischen Anschlussleitung 14 sein. Die Beschaffenheit der Anschlussleitung 10 ist bzw. wird durch wenigstens ein Ausgewähltes aus einer Länge L der elektrischen Anschlussleitung 10, einem elektrischen Widerstandswert RA der elektrischen Anschlussleitung 10, einem elektrischen Kapazitätswert CA der Anschlussleitung 10 und einem elektrischen Induktivitätswert LA der Anschlussleitung 10 festgelegt. Dabei wird gemäß dem Verfahren die Beschaffenheit der Anschlussleitung 10 ermittelt. Die Anschlussleitung 10 legt den Pilotabschnitt 6 und den Masseabschnitt 7 des elektrischen Leitungspfads 4 in einem Bereich 11 fest, der außerhalb eines von einem Gehäuse 21 der elektrischen Ladestation 20 begrenzten Gehäuseinnenraums 2 und 20 vorhanden ist. Dabei sind die Frequenzfiltereinrichtung 9, der Oszillator 5, die Kapazität CS und ein abseits der Anschlussleitung 10 gelegener Restbereich 12 des elektrischen Leitungspfads 4 im Gehäuseinnenraum 22 angeordnet.

Die Frequenzfiltereinrichtung 9 weist einen elektrischen Filterwiderstandswert RF und einen elektrischen Filterkapazitätswert CF und einen elektrischen Induktivitätswert LF auf. Der Filterwiderstandswert RF, der Filterkapazitätswert CF und der Induktivitätswert LF sind jeweils zu gleich oder größer null parametrisierbar. Der Filterwiderstandswert RF kann also zu gleich oder größer 0 Ohm parametrisiert werden. Der Filterkapazitätswert CF kann zu gleich oder größer 0 Farad parametrisiert werden. Der Filterinduktivitätswert LF kann zu gleich oder größer 0 Henry parametrisiert werden. Beispielsweise wird die Frequenzfiltereinrichtung anhand einer Wertetabelle parametrisiert. In dieser Wertetabelle sind inkrementelle Beschaffenheitswerte inkrementellen Parameterwerten zugeordnet. In der Wertetabelle sind beispielsweise Beschaffenheitswerte für wenigstens ein Ausgewähltes aus der Länge L der elektrischen Anschlussleitung 10, dem elektrischen Widerstandswert RA der Anschlussleitung 10, dem elektrischen Kapazitätswert CA der elektrischen Anschlussleitung 10 und dem elektrischen Induktivitätswert der Anschlussleitung 10 abgelegt. In der Wertetabelle sind beispielsweise inkrementelle Parameterwerte für den elektrischen Filterwiderstandswert RF und den elektrischen Filterkapazitätswert CF und den elektrischen Filterinduktivitätswert LF abgelegt.

Bei einer ersten und einer zweiten Variante des Verfahrens werden der Pilot- und der Massekontakt 2, 3 beim Ermitteln der Beschaffenheit der Anschlussleitung 10 elektrisch kurzgeschlossen.

Gemäß der ersten Variante des Verfahrens wird dem Pilotabschnitt 2 des elektrischen Leitungspfads 4 ein elektrischer Messwiderstand mit vorbestimmtem Messwiderstandswert elektrisch in Reihe geschaltet. Dann wird mittels einer elektrischen Spannungsquelle eine konstante elektrische Spannung eines vorbestimmten über die Zeit konstanten Spannungswerts erzeugt und an einem vom Pilotkontakt 2 und vom Massekontakt 3 abgewandten gemeinsamen Ende der Anschlussleitung 10 an den Pilotabschnitt 6 und an den Masseabschnitt 7 angelegt. Dabei wird ein Spannungswert der über den Messwiderstand abfallenden elektrischen Spannung gemessen. Bei dieser Variante ist die Beschaffenheit der Anschlussleitung 10 wenigstens durch den elektrischen Widerstandswert RA der Anschlussleitung 10 festgelegt, wobei der elektrische Widerstandswert RA der Anschlussleitung 10 aus den Spannungswerten der vorbestimmten konstanten elektrischen Spannung und der gemessenen über den Messwiderstand abfallenden elektrischen Spannung berechnet wird.

Die Berechnung des elektrischen Widerstandswerts RA der Anschlussleitung 10 kann bei der ersten Variante des Verfahrens mittels nachfolgender Formel A berechnet werden:

$$RA = \frac{R_{bekannt} * U_{Leitung}}{U_{konstant} - U_{Leitung}} \qquad \text{(Formel A)},$$

wobei $R_{bekannt}$ der elektrische Messwiderstandswert, $U_{konstant}$ der elektrische Spannungswert der mittels der Spannungsquelle erzeugten konstanten elektrischen Spannung und $U_{Leitung}$ die Differenz zwischen $U_{konstant}$ und dem Spannungswert der über den Messwiderstand abfallenden Spannung ist.

Gemäß der zweiten Variante des Verfahrens wird mittels einer elektrischen Stromquelle ein konstanter elektrischer Strom vorbestimmter und über die Zeit konstanter Stromstärke erzeugt und am vom Pilotkontakt 2 und vom Massekontakt 3 abgewandten gemeinsamen Ende der Anschlussleitung 10 an den Pilotabschnitt 6 und den Masseabschnitt 7 angelegt. Dabei wird ein Spannungswert der über den Pilotabschnitt 6 und den Masseabschnitt 7 abfallenden elektrischen Spannung gemessen. Bei dieser Variante ist die Beschaffenheit der Anschlussleitung 10 wenigstens durch den elektrischen Widerstandswert RA der Anschlussleitung 10 festgelegt, wobei der elektrische Widerstandswert RA der Anschlussleitung 10 aus der vorbestimmten Stromstärke und dem gemessenen Spannungswert der über den Pilotabschnitt 6 und den Masseabschnitt 7 abfallenden elektrischen Spannung berechnet wird.

Die Berechnung des elektrischen Widerstandswerts RA der Anschlussleitung 10 kann bei der zweiten Variante des Verfahrens mittels nachfolgender Formel B berechnet werden:

$$RA = \frac{U_{Leitung}}{I_{konstant}} \qquad \text{(Formel B)},$$

wobei $U_{Leitung}$ der elektrische Spannungswert der über den Pilotabschnitt und den Masseabschnitt abfallenden elektrischen Spannung und $I_{konstant}$ die elektrische Stromstärke des mittels der elektrischen Stromquelle erzeugten konstanten elektrischen Stroms ist.

Sowohl bei der ersten als auch bei der zweiten Variante des Verfahrens kann die Beschaffenheit der Anschlussleitung 10 zusätzlich wenigstens durch die Länge L der Anschlussleitung 10 festgelegt sein. Dabei kann die Länge L der Anschlussleitung 10 aus einem vorbestimmten elektrischen Widerstandsbelag R' der Anschlussleitung 10 und dem berechneten elektrischen Widerstandswert RA der Anschlussleitung 10 berechnet werden.

Die Berechnung der Länge L der Anschlussleitung RA kann bei der ersten und der zweiten Variante des Verfahrens mittels nachfolgender Formel B erfolgen:

$$L = \frac{RA}{R'} \qquad \text{(Formel C)}.$$

Der Widerstandsbelag R' der Anschlussleitung 10 kann zuvor anhand von Messungen oder anhand eines Datenblatts oder aus einschlägigen Tabellenbüchern für das Verfahren vorbestimmt werden. Dabei kann sich eine vorherige Messung des Widerstandsbelags R' an einer Probe der Anschlussleitung 10 bekannter Leitungslänge als vorteilhaft erweisen, da so Übergangswiderstände im Messergebnis direkt mit berücksichtigt werden.

In einer dritten Variante des Verfahrens ist die Beschaffenheit der Anschlussleitung 10 wenigstens durch die Länge L der Anschlussleitung 10 bestimmt. Dabei wird mittels einer elektrischen Spannungsimpulsquelle ein elektrischer Spannungsimpuls erzeugt und von einem vom Pilotkontakt 2 abgewandten Ende der Anschlussleitung 10 ausgehend durch den in der Anschlussleitung 10 vorhandenen Bereich 11 des Pilotabschnitts 6 geschickt, wobei der Pilotkontakt 2 frei liegt. Der Spannungsimpuls wird am Pilotkontakt 2 reflektiert. Der reflektierte Spannungsimpuls wird am vom Pilotkontakt 2 abgewandten Ende der Anschlussleitung 10 detektiert. Dabei wird eine Laufzeit zwischen Erzeugung des Spannungsimpulses und Detektion des reflektierten Spannungsimpulses gemessen. Anhand einer vorbestimmten Ausbreitungsgeschwindigkeit c elektrischer Spannung auf der Anschlussleitung 10 und der gemessenen Laufzeit wird dann die Länge L der Anschlussleitung 10 berechnet.

Gemäß einer vierten Variante des Verfahrens ist die Beschaffenheit der Anschlussleitung 10 wenigstens durch den elektrischen Kapazitätswert CA der Anschlussleitung 10 festgelegt. Dabei wird der Kapazitätswert CA der Anschlussleitung 10 gemessen.

Bei allen Varianten des Verfahrens kann die Frequenzfiltereinrichtung 9 analog sowie - alternativ oder zusätzlich - digital ausgelegt, beispielsweise parametrisiert, werden.

**Patentansprüche**

1. Elektronische Schaltungsanordnung (1) für eine elektrische Ladestation (20), wobei mittels der Schaltungsanordnung (1) eine elektrische Kommunikationsverbindung (30) zwischen der elektrischen Ladestation (20) und einem mittels der Ladestation (20) mit elektrischer Energie aufladbaren Elektrokraftfahrzeug (31) ausbildbar ist,

   - mit einem elektrischen Pilotkontakt (2) und mit einem elektrischen Massekontakt (3), an welche das Elektrokraftfahrzeug (31) zur Ausbildung der elektrischen Kommunikationsverbindung (30) elektrisch anschließbar ist,
   - mit einem elektrischen Leitungspfad (4), in welchem ein elektrischer Oszillator (5) angeordnet ist,
   - wobei der Oszillator (5) den elektrischen Leitungspfad (4) zumindest in einen dem Oszillator (5) abgewandt im Pilotkontakt (2) endenden Pilotabschnitt (6) und in einen dem Oszillator (5) abgewandt im Massekontakt (3) endenden Masseabschnitt (7) unterteilt,
   - wobei ein elektrischer Parallel-Leitungspfad (8), in welchem eine elektrische Kapazität (CS) angeordnet ist, mit dem Pilotabschnitt (6) und dem Masseabschnitt (7) elektrisch parallel zum Oszillator (5) verbunden ist, wobei
   - der elektrische Oszillator (5) zum Erzeugen eines pulsweitenmodulierten elektrischen Kommunikationssignals (S) ausgebildet ist, und wobei
   - im Pilotabschnitt (6) des elektrischen Leitungspfades (4) eine parametrisierbare Frequenzfiltereinrichtung (9) zum Filtern des elektrischen Kommunikationssignals (K) angeordnet ist; und wobei
   - im Pilotabschnitt (6) eine elektrische Spannungsmesseinrichtung, mittels welcher eine zwischen Pilot- und Massekontakt (2, 3) anliegende elektrische Spannung messbar ist, und zwischen Pilotkontakt (2) und parametrisierbarer Frequenzfiltereinrichtung (9) elektrisch an den elektrischen Leitungspfad (4) angeschlossen ist; und wobei
   - die Frequenzfiltereinrichtung (9) einen Hochpassfilter (13) oder/und einen Bandpassfilter umfasst und in Abhängigkeit von der Beschaffenheit, insbesondere der elektrischen Impedanz, einer den Pilotabschnitt (6) und den Masseabschnitt (7) des elektrischen Leitungspfads (4) wenigstens bereichsweise festlegenden elektrischen Anschlussleitung (10) parametrisierbar ist, wobei die Beschaffenheit der Anschlussleitung (10) wenigstens durch ein Ausgewähltes aus einer Länge (L) der elektrischen Anschlussleitung (10), einem elektrischen Widerstandswert (RA) der Anschlussleitung (10), einem elektrischen Kapazitätswert (CA) der Anschlussleitung (10) und einem elektrischen Induktivitätswert (LA) der Anschlussleitung (10) festgelegt ist.

2. Verfahren zum Auslegen einer elektrischen Frequenzfiltereinrichtung (9) der elektronischen Schaltungsanordnung (1) nach Anspruch 1, gemäß welchem

- die Frequenzfiltereinrichtung (9) in Abhängigkeit von der Beschaffenheit, insbesondere der elektrischen Impedanz, einer den Pilotabschnitt (6) und den Masseabschnitt (7) des elektrischen Leitungspfads (4) wenigstens bereichsweise festlegenden elektrischen Anschlussleitung (10) parametrisiert wird,
- die Beschaffenheit der Anschlussleitung (10) wenigstens durch ein Ausgewähltes aus einer Länge (L) der elektrischen Anschlussleitung (10), einem elektrischen Widerstandswert (RA) der Anschlussleitung (10), einem elektrischen Kapazitätswert (CA) der Anschlussleitung (10) und einem elektrischen Induktivitätswert (LA) der Anschlussleitung (10) festgelegt wird.

3. Verfahren nach Anspruch 2,
**dadurch gekennzeichnet, dass**
gemäß dem Verfahren die Beschaffenheit der Anschlussleitung (10) ermittelt wird.

4. Verfahren nach Anspruch 2 oder 3,
**dadurch gekennzeichnet, dass**

- die Anschlussleitung (10) den Pilotabschnitt (6) und den Masseabschnitt (7) des elektrischen Leitungspfads (4) in einem Bereich (11) festlegt, der außerhalb eines von einem Gehäuse (21) der elektrischen Ladestation (20) begrenzten Gehäuseinnenraums (22) vorhanden ist,
- wobei im Gehäuseinnenraum (22) die Frequenzfiltereinrichtung (9), der Oszillator (5), die Kapazität (CS) und ein abseits der Anschlussleitung (10) gelegener Restbereich (12) des elektrischen Leitungspfades (4) angeordnet sind.

5. Verfahren nach einem der Ansprüche 2 bis 4,
**dadurch gekennzeichnet, dass**

- die Frequenzfiltereinrichtung (9) einen elektrischen Filterwiderstandswert (RF) und einen elektrischen Filterkapazitätswert (CF) und einen elektrischen Filterinduktivitätswert (LF) aufweist, die jeweils zu gleich oder größer null parametrisierbar sind,
- die Frequenzfiltereinrichtung (9) anhand einer Wertetabelle parametrisiert wird, in welcher inkrementelle Beschaffenheitswerte für wenigstens ein Ausgewähltes aus der Länge (L) der elektrischen Anschlussleitung (10), dem elektrischen Widerstandswert (RA) der Anschlussleitung (10), dem elektrischen Kapazitätswert (CA) der Anschlussleitung (10) und dem elektrischen Induktivitätswert (LA) der Anschlussleitung (10) inkrementellen Parameterwerten für den elektrischen Filterwiderstandswert (RF) und den elektrischen Filterkapazitätswert (CF) und den elektrischen Filterinduktivitätswert (LF) zugeordnet sind.

6. Verfahren nach einem der Ansprüche 2 bis 5,
**dadurch gekennzeichnet, dass**
der Pilot- und der Massekontakt (2, 3) beim Ermitteln der Beschaffenheit der Anschlussleitung (10) elektrisch kurzgeschlossen werden.

7. Verfahren nach Anspruch 6,
**dadurch gekennzeichnet, dass**

- dem Pilotabschnitt (2) des elektrischen Leitungspfads (4) ein elektrischer Messwiderstand mit vorbestimmtem Messwiderstandswert elektrisch in Reihe geschaltet wird,
- mittels einer elektrischen Spannungsquelle eine konstante elektrische Spannung vorbestimmten Spannungswerts erzeugt und an einem vom Pilotkontakt (2) und vom Massekontakt (3) abgewandten gemeinsamen Ende der Anschlussleitung (10) an den Pilotabschnitt (6) und den Masseabschnitt (7) angelegt wird,
- ein Spannungswert der über den Messwiderstand abfallenden elektrischen Spannung gemessen wird,
- die Beschaffenheit der Anschlussleitung (10) wenigstens durch den elektrischen Widerstandswert (RA) der Anschlussleitung (10) festgelegt ist/wird, der aus den Spannungswerten der vorbestimmten konstanten elektrischen Spannung und der gemessenen über den Messwiderstand abfallenden elektrischen Spannung berechnet wird.

8. Verfahren nach Anspruch 6,
**dadurch gekennzeichnet, dass**

- mittels einer elektrischen Stromquelle ein konstanter elektrischer Strom vorbestimmter Stromstärke erzeugt und an einem vom Pilotkontakt (2) und vom Massekontakt (3) abgewandten gemeinsamen Ende der Anschlussleitung (10) an den Pilotabschnitt (6) und den Masseabschnitt (7) angelegt wird,
- ein Spannungswert der über den Pilotabschnitt (6) und den Masseabschnitt (7) abfallenden elektrischen Spannung gemessen wird,
- die Beschaffenheit der Anschlussleitung (10) wenigstens durch den elektrischen Widerstandswert (RA) der Anschlussleitung (10) festgelegt ist/wird, der aus der vorbestimmten Stromstärke und dem gemessenen Spannungswert der über den Pilotabschnitt (6) und den Masseabschnitt (7) abfallende elektrischen Spannung berechnet wird.

9. Verfahren nach Anspruch 7 oder 8,
   **dadurch gekennzeichnet, dass**

   - die Beschaffenheit der Anschlussleitung (10) zusätzlich wenigstens durch die Länge (L) der Anschlussleitung (10) festgelegt ist/wird,
   - die Länge (L) der Anschlussleitung (10) aus einem vorbestimmten elektrischen Widerstandsbelag (R') der Anschlussleitung (10) und dem berechneten elektrischen Widerstandswert (RA) der Anschlussleitung (10) berechnet wird.

10. Verfahren nach einem der Ansprüche 2 bis 5,
    **dadurch gekennzeichnet, dass**

    - die Beschaffenheit der Anschlussleitung (10) wenigstens durch die Länge (L) der Anschlussleitung (10) bestimmt ist/wird,
    - mittels einer elektrischen Spannungsimpulsquelle ein elektrischer Spannungsimpuls erzeugt und von einem vom Pilotkontakt (2) abgewandten Ende der Anschlussleitung (10) ausgehend durch den in der Anschlussleitung (10) vorhandenen Bereich (11) des Pilotabschnitts (6) geschickt wird, wobei der Pilotkontakt (2) frei liegt,
    - der Spannungsimpuls am Pilotkontakt (2) reflektiert wird,
    - der reflektierte Spannungsimpuls am vom Pilotkontakt (2) abgewandten Ende der Anschlussleitung (10) detektiert wird,
    - eine Laufzeit zwischen Erzeugung des Spannungsimpulses und Detektion des reflektierten Spannungsimpulses gemessen wird,
    - anhand einer vorbestimmten Ausbreitungsgeschwindigkeit (c) elektrischer Spannung auf der Anschlussleitung (10) und der gemessenen Laufzeit die Länge (L) der Anschlussleitung (10) berechnet wird.

11. Verfahren nach einem der Ansprüche 2 bis 5,
    **dadurch gekennzeichnet, dass**

    - die Beschaffenheit der Anschlussleitung (10) wenigstens durch den elektrischen Kapazitätswert (CA) der Anschlussleitung (10) festgelegt ist/wird,
    - der Kapazitätswert (CA) der Anschlussleitung (10) gemessen wird.

12. Schaltungsanordnung (1) nach Anspruch 1,
    **dadurch gekennzeichnet, dass**
    die Frequenzfiltereinrichtung (9) analog oder/und digital auslegbar bzw. ausgelegt, insbesondere parametrisierbar bzw. parametrisiert, ist/wird.

13. Schaltungsanordnung (1) nach Anspruch 1 oder 12,
    **dadurch gekennzeichnet, dass**
    die Frequenzfiltereinrichtung (9) genau einen elektrischen Widerstand (R1) und genau eine elektrische Kapazität (C1) umfasst, wobei die Kapazität (C1) dem Widerstand (R1) elektrisch parallel geschaltet ist.

**Claims**

1. An electronic circuit arrangement (1) for an electric charging station (20),

   wherein an electrical communication connection (30) can be formed, by means of the circuit arrangement (1), between the electric charging station (20) and an electric motor vehicle (31) which can be charged with electrical energy by means of the charging station (20),

   - having an electrical pilot contact (2) and having an electrical earth contact (3), to which the electric motor vehicle (31) can be electrically connected to form the electrical communication connection (30),
   - having an electrical line path (4) in which an electrical oscillator (5) is arranged,
   - wherein the oscillator (5) divides the electrical line path (4) at least into a pilot portion (6) ending in the pilot contact (2) facing away from the oscillator (5) and into an earth portion (7) ending in the earth contact (3) facing away from the oscillator (5),
   - wherein an electrical parallel line path (8), in which an electrical capacitor (CS) is arranged, is electrically connected to the pilot portion (6) and to the earth portion (7) in parallel with the oscillator (5),

   wherein

- the electrical oscillator (5) is designed to generate a pulse-width modulated electrical communication signal (S), and wherein

- a parameterizable frequency filter device (9) for filtering the electrical communication signal (K) is arranged in the pilot portion (6) of the electrical line path (4); and wherein

- in the pilot portion (6), an electrical voltage-measuring device, by means of which an electrical voltage applied between the pilot contact and earth contact (2, 3) can be measured, is electrically connected to the electrical line path (4) between the pilot contact (2) and parameterizable frequency filter device (9); and wherein

- the frequency filter device (9) comprises a high-pass filter (13) and/or a band-pass filter and can be parameterized depending on the quality, in particular the electrical impedance, of an electrical connecting line (10) which defines the pilot portion (6) and the earth portion (7) of the electrical line path (4) at least in some regions, wherein the quality of the connecting line (10) is defined at least by one selected from a length (L) of the electrical connecting line (10), an electrical resistance value (RA) of the connecting line (10), an electrical capacitance value (CA) of the connecting line (10) and an electrical inductance value (LA) of the connecting line (10).

2. A method for designing an electrical frequency filter device (9) of the electronic circuit arrangement (1) according to claim 1, according to which

- the frequency filter device (9) is parameterized depending on the quality, in particular the electrical impedance, of an electrical connecting line (10) which defines the pilot portion (6) and the earth portion (7) of the electrical line path (4) at least in some regions,

- the quality of the connecting line (10) is determined at least by one selected from a length (L) of the electrical connecting line (10), an electrical resistance value (RA) of the connecting line (10), an electrical capacitance value (CA) of the connecting line (10) and an electrical inductance value (LA) of the connecting line (10).

3. The method according to claim 2,
**characterized in that**
the nature of the connecting line (10) is determined according to the method.

4. The method according to claim 2 or 3,
**characterized in that**

- the connecting line (10) defines the pilot portion (6) and the earth portion (7) of the electrical line path (4) in a region (11) which is located outside a housing interior (22) delimited by a housing (21) of the electric charging station (20),

- the frequency filter device (9), the oscillator (5), the capacitor (CS) and a residual region (12) of the electrical line path (4) located away from the connecting line (10) being arranged in the housing interior (22).

5. The method according to any of claims 2 to 4,
**characterized in that**

- the frequency filter device (9) has an electrical filter resistance value (RF) and an electrical filter capacitance value (CF) and an electrical filter inductance value (LF), which can each be parameterized to be equal to or greater than zero,

- the frequency filter device (9) is parameterized using a value table in which incremental quality values for at least one selected from the length (L) of the electrical connecting line (10), the electrical resistance value (RA) of the connecting line (10), the electrical capacitance value (CA) of the connecting line (10) and the electrical inductance value (LA) of the connecting line (10) are assigned incremental parameter values for the electrical filter resistance value (RF) and the electrical filter capacitance value (CF) and the electrical filter inductance value (LF).

6. The method according to any of claims 2 to 5,
**characterized in that**
the pilot contact and the earth contact (2, 3) are electrically short-circuited when determining the quality of the connecting line (10).

7. The method according to claim 6,
**characterized in that**

- an electrical measuring resistor having a predetermined measuring resistance value is electrically connected in series with the pilot portion (2) of the electrical line path (4),

- a constant electrical voltage of a predetermined voltage value is generated by means of an electrical voltage source and is applied to the pilot portion (6) and the earth portion (7) at a common end of the connecting line (10) facing away from the pilot contact (2) and the earth contact (3),

- a voltage value of the electrical voltage dropping across the measuring resistor is measured,

- the quality of the connecting line (10) is determined at least by the electrical resistance value (RA) of the connecting line (10), which is calculated from the voltage values of the predetermined constant electrical voltage and the measured electrical voltage dropping across the measuring resistor.

8.  The method according to claim 6, **characterized in that**

    - a constant electrical current of predetermined current intensity is generated by means of an electrical current source and is applied to the pilot portion (6) and the earth portion (7) at a common end of the connecting line (10) facing away from the pilot contact (2) and the earth contact (3),
    - a voltage value of the electrical voltage dropping across the pilot portion (6) and the earth portion (7) is measured,
    - the quality of the connecting line (10) is determined at least by the electrical resistance value (RA) of the connecting line (10), which is calculated from the predetermined current intensity and the measured voltage value of the electrical voltage dropping across the pilot portion (6) and the earth portion (7).

9.  The method according to claim 7 or 8, **characterized in that**

    - the quality of the connecting line (10) is additionally determined at least by the length (L) of the connecting line (10),
    - the length (L) of the connecting line (10) is calculated from a predetermined electrical resistance load per unit length (R') of the connecting line (10) and the calculated electrical resistance value (RA) of the connecting line (10).

10. The method according to any of claims 2 to 5, **characterized in that**

    - the quality of the connecting line (10) is determined at least by the length (L) of the connecting line (10),
    - an electrical voltage pulse is generated by means of an electrical voltage pulse source and is sent from an end of the connecting line (10) facing away from the pilot contact (2) through the region (11) of the pilot portion (6) located in the connecting line (10), the pilot contact (2) being exposed
    - the voltage pulse is reflected at the pilot contact (2),
    - the reflected voltage pulse is detected at the end of the connecting line (10) facing away from the pilot contact (2),
    - a transit time between generating the voltage pulse and detecting the reflected voltage pulse is measured,

    - the length (L) of the connecting line (10) is calculated using a predetermined propagation speed (c) of electrical voltage on the connecting line (10) and the measured transit time.

11. The method according to any of claims 2 to 5, **characterized in that**

    - the quality of the connecting line (10) is determined at least by the electrical capacitance value (CA) of the connecting line (10),
    - the capacitance value (CA) of the connecting line (10) is measured.

12. The circuit arrangement (1) according to claim 1, **characterized in that**
    the frequency filter device (9) can be or is designed to be analogue and/or digital, in particular can be or is parameterized.

13. The circuit arrangement (1) according to claim 1 or 12, **characterized in that**
    the frequency filter device (9) comprises exactly one electrical resistor (R1) and exactly one electrical capacitor (C1), the capacitor (C1) being electrically connected in parallel to the resistor (R1).

**Revendications**

1.  Circuit (1) électronique pour une station de charge électrique (20),

    dans lequel une liaison de communication électrique (30) entre la station de charge électrique (20) et un véhicule automobile électrique (31) pouvant être rechargé en énergie électrique au moyen de la station de charge (20) peut être formée au moyen du circuit (1),

       - comportant un contact pilote (2) électrique et comportant un contact de masse (3) électrique auxquels le véhicule automobile électrique (31) peut être connecté électriquement pour former la liaison de communication électrique (30),
       - comportant un chemin de conduction électrique (4) dans lequel est disposé un oscillateur (5) électrique,
       - dans lequel l'oscillateur (5) divise le chemin de conduction électrique (4) au moins en une section pilote (6) se terminant dans le contact pilote (2) à l'opposé de l'oscillateur (5) et en une section de masse (7) se terminant dans le contact de masse (3) à l'opposé de l'oscillateur (5),
       - dans lequel un chemin de conduction électrique parallèle (8), dans lequel est disposée une capacité (CS) électrique, est relié électriquement à la section pilote (6) et à la section de masse (7) en parallèle avec l'oscillateur (5),

dans lequel

- l'oscillateur (5) électrique est configuré pour générer un signal de communication électrique (S) à impulsions modulées en largeur, et dans lequel
- un dispositif de filtrage de fréquence (9) paramétrable est disposé dans la section pilote (6) du chemin de conduction électrique (4) pour filtrer le signal de communication électrique (K) ; et dans lequel
- dans la section pilote (6) un dispositif de mesure de tension électrique, au moyen duquel une tension électrique appliquée entre le contact pilote et le contact de masse (2, 3) peut être mesurée, et est connecté électriquement au chemin de conduction électrique (4) entre le contact pilote (2) et le dispositif de filtrage de fréquence (9) paramétrable ; et dans lequel
- le dispositif de filtrage de fréquence (9) comprend un filtre passe-haut (13) ou/et un filtre passe-bande et peut être paramétré en fonction de la nature, en particulier de l'impédance électrique, d'une ligne de connexion (10) électrique définissant, au moins dans certaines zones, la section pilote (6) et la section de masse (7) du chemin de conduction électrique (4), dans lequel la nature de la ligne de connexion (10) est définie au moins par un élément sélectionné parmi une longueur (L) de la ligne de connexion (10) électrique, une valeur de résistance électrique (RA) de la ligne de connexion (10), une valeur de capacité électrique (CA) de la ligne de connexion (10) et une valeur d'inductance électrique (LA) de la ligne de connexion (10).

2. Procédé pour la conception d'un dispositif de filtrage de fréquence (9) électrique du circuit (1) électronique selon la revendication 1, dans lequel

- le dispositif de filtrage de fréquence (9) est paramétré en fonction de la nature, en particulier de l'impédance électrique, d'une ligne de connexion (10) électrique définissant, au moins dans certaines zones, la section pilote (6) et la section de masse (7) du chemin de conduction électrique (4),
- la nature de la ligne de connexion (10) est définie au moins par un élément sélectionné parmi une longueur (L) de la ligne de connexion (10) électrique, une valeur de résistance électrique (RA) de la ligne de connexion (10), une valeur de capacité électrique (CA) de la ligne de connexion (10) et une valeur d'inductance électrique (LA) de la ligne de connexion (10).

3. Procédé selon la revendication 2,
**caractérisé en ce que**
la nature de la ligne de connexion (10) est déterminée conformément au procédé.

4. Procédé selon la revendication 2 ou 3,
**caractérisé en ce que**

- la ligne de connexion (10) définit la section pilote (6) et la section de masse (7) du chemin de conduction électrique (4) dans une zone (11) qui est présente à l'extérieur d'un espace intérieur de boîtier (22) délimité par un boîtier (21) de la station de charge électrique (20),
- dans lequel le dispositif de filtrage de fréquence (9), l'oscillateur (5), la capacité (CS) et une zone restante (12) du chemin de conduction électrique (4) située à l'écart de la ligne de connexion (10) sont disposés dans l'espace intérieur de boîtier (22).

5. Procédé selon l'une des revendications 2 à 4,
**caractérisé en ce que**

- le dispositif de filtrage de fréquence (9) présente une valeur de résistance de filtre électrique (RF) et une valeur de capacité de filtre électrique (CF) et une valeur d'inductance de filtre électrique (LF) qui peuvent être paramétrées respectivement pour être égales ou supérieures à zéro,
- le dispositif de filtrage de fréquence (9) est paramétré à l'aide d'un tableau de valeurs dans lequel des valeurs de natures incrémentielles pour au moins un élément sélectionné parmi la longueur (L) de la ligne de connexion (10) électrique, la valeur de résistance électrique (RA) de la ligne de connexion (10), la valeur de capacité électrique (CA) de la ligne de connexion (10) et la valeur d'inductance électrique (LA) de la ligne de connexion (10) sont associées à des valeurs de paramètres incrémentielles pour la valeur de résistance de filtre électrique (RF) et la valeur de capacité de filtre électrique (CF) et la valeur d'inductance de filtre électrique (LF).

6. Procédé selon l'une des revendications 2 à 5,
**caractérisé en ce que**
le contact pilote et le contact de masse (2, 3) sont court-circuités électriquement lors de la détermination de la nature de la ligne de connexion (10).

**7.** Procédé selon la revendication 6, **caractérisé en ce que**

- une résistance de mesure électrique comportant une valeur de résistance de mesure prédéterminée est montée électriquement en série avec la section pilote (2) du chemin de conduction électrique (4),
- une tension électrique constante d'une valeur de tension prédéterminée est générée au moyen d'une source de tension électrique et est appliquée à la section pilote (6) et à la section de masse (7) à une extrémité commune de la ligne de connexion (10) opposée au contact pilote (2) et au contact de masse (3),
- une valeur de tension de la tension électrique chutant aux bornes de la résistance de mesure est mesurée,
- la nature de la ligne de connexion (10) est définie au moins par la valeur de résistance électrique (RA) de la ligne de connexion (10), laquelle valeur est calculée à partir des valeurs de tension de la tension électrique constante prédéterminée et de la tension électrique mesurée chutant aux bornes de la résistance de mesure.

**8.** Procédé selon la revendication 6, **caractérisé en ce que**

- un courant électrique constant d'intensité de courant prédéterminée est généré au moyen d'une source de courant électrique et est appliqué à la section pilote (6) et à la section de masse (7) à une extrémité commune de la ligne de connexion (10) opposée au contact pilote (2) et au contact de masse (3),
- une valeur de tension de la tension électrique chutant aux bornes de la section pilote (6) et de la section de masse (7) est mesurée,
- la nature de la ligne de connexion (10) est définie au moins par la valeur de résistance électrique (RA) de la ligne de connexion (10), laquelle valeur est calculée à partir de l'intensité de courant prédéterminée et de la valeur de tension mesurée de la tension électrique chutant aux bornes de la section pilote (6) et de la section de masse (7).

**9.** Procédé selon la revendication 7 ou 8, **caractérisé en ce que**

- la nature de la ligne de connexion (10) est en outre définie au moins par la longueur (L) de la ligne de connexion (10),
- la longueur (L) de la ligne de connexion (10) est calculée à partir d'un revêtement de résistance (R') électrique prédéterminé de la ligne de connexion (10) et de la valeur de résistance électrique (RA) calculée de la ligne de connexion (10).

**10.** Procédé selon l'une des revendications 2 à 5, **caractérisé en ce que**

- la nature de la ligne de connexion (10) est déterminée au moins par la longueur (L) de la ligne de connexion (10),
- une impulsion de tension électrique est générée au moyen d'une source d'impulsions de tension électrique et est envoyée à partir d'une extrémité de la ligne de connexion (10) opposée au contact pilote (2) à travers la zone (11) de la section pilote (6) présente dans la ligne de connexion (10), dans lequel le contact pilote (2) est dégagé,
- l'impulsion de tension est réfléchie sur le contact pilote (2),
- l'impulsion de tension réfléchie est détectée à l'extrémité de la ligne de connexion (10) opposée au contact pilote (2),
- un temps de propagation entre la génération de l'impulsion de tension et la détection de l'impulsion de tension réfléchie est mesuré,
- la longueur (L) de la ligne de connexion (10) est calculée à l'aide d'une vitesse de propagation (c) prédéterminée de la tension électrique sur la ligne de connexion (10) et du temps de propagation mesuré.

**11.** Procédé selon l'une des revendications 2 à 5, **caractérisé en ce que**

- la nature de la ligne de connexion (10) est définie au moins par la valeur de capacité électrique (CA) de la ligne de connexion (10),
- la valeur de capacité (CA) de la ligne de connexion (10) est mesurée.

**12.** Circuit (1) selon la revendication 1, **caractérisé en ce que** le dispositif de filtrage de fréquence (9) peut être conçu ou est conçu de manière à être analogique ou/et numérique, en particulier de manière à être paramétrable ou paramétré.

**13.** Circuit (1) selon la revendication 1 ou 12, **caractérisé en ce que** le dispositif de filtrage de fréquence (9) comprend exactement une résistance (R1) électrique et exactement une capacité (C1) électrique, dans lequel la capacité (C1) est montée électriquement en parallèle avec la résistance (R1).

Fig. 1

Fig. 2

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 2014247893 A1
- EP 2197084 A1